Europäisches Patentamt

European Patent Office

Office européen des brevets

(11) Veröffentlichungsnummer : **0 248 395 B1**

(12)

# EUROPÄISCHE PATENTSCHRIFT

(45) Veröffentlichungstag der Patentschrift :
**05.06.91 Patentblatt 91/23**

(51) Int. Cl.⁵ : **G03F 7/027**, G03F 7/033

(21) Anmeldenummer : **87107944.8**

(22) Anmeldetag : **02.06.87**

(54) Lichtempfindliches Aufzeichnungselement.

(30) Priorität : **06.06.86 DE 3619129**

(43) Veröffentlichungstag der Anmeldung :
**09.12.87 Patentblatt 87/50**

(45) Bekanntmachung des Hinweises auf die
Patenterteilung :
**05.06.91 Patentblatt 91/23**

(84) Benannte Vertragsstaaten :
**AT BE CH DE ES FR GB IT LI NL SE**

(56) Entgegenhaltungen :
**EP-A- 0 152 889
EP-A- 0 186 844**

(56) Entgegenhaltungen :
**EP-A- 0 209 803
DE-A- 1 797 373
US-A- 3 469 982
US-A- 3 796 578
US-A- 4 001 015
US-A- 4 427 760**

(73) Patentinhaber : **BASF Aktiengesellschaft
Carl-Bosch-Strasse 38
W-6700 Ludwigshafen (DE)**

(72) Erfinder : **Hofmann, Reiner, Dr.
Mandelbergstrasse 44
W-6730 Neustadt (DE)**
Erfinder : **Sanner, Axel, Dr.
Lorscher Ring 2 s
W-6710 Frankenthal (DE)**

## Beschreibung

Die Erfindung betrifft ein lichtempfindliches Aufzeichnungselement mit einer auf einem Träger aufgebrachten, wäßrig-alkalisch entwickelbaren, ein polymeres Bindemittel enthaltenden, photopolymerisierbaren Aufzeichnungsschicht, welches insbesondere für die Herstellung von Druckformen oder Resistmustern geeignet ist.

Die bekannten, mit wäßrig-alkalischen Entwicklerlösungen auswaschbaren, lichtempfindlichen Aufzeichnungselemente für die Herstellung von photopolymeren Druckformen oder Resistmustern enthalten auf einem dimensionsstabilen Träger, z.B. einer Kunststoff-Folie oder einem Metallblech, eine photopolymerisierbare Aufzeichnungsschicht aus einer Mischung von mindestens einem in den wäßrig-alkalischen Entwicklerlösungen löslichen oder dispergierbaren polymeren Bindemittel, mindestens einer ethylenisch ungesättigten, photopolymerisierbaren, niedermolekularen Verbindung, mindestens einem Photoinitiator sowie gegebenenfalls weiteren die verarbeitungs- und/oder anwendungstechnischen Eigenschaften verbessernden und/oder modifizierenden Zusatz- und/oder Hilfsstoffen.

Als polymere Bindemittel für die wäßrig-alkalisch entwickelbaren photopolymerisierbaren Aufzeichnungsschichten gelangen hierbei insbesondere in den wäßrig-alkalischen Entwicklerlösungsmitteln lösliche oder zumindest dispergierbare, carboxylgruppenhaltige oder Carbonsäureanhydrid-Gruppen enthaltende Copolymerisate zur Anwendung, wie z.B. Styrol/Maleinsäureanhydrid-Copolymerisate, Styrol/Maleinsäurehalbester-Copolymerisate, Alkyl(meth)acrylat/(Meth)acrylsäure-Copolymerisate oder auch Copolymerisate aus Styrol, Alkyl(meth)acrylaten und (Meth)acrylsäure sowie gegebenenfalls anderen Comonomeren (vgl. u.a. DE-B-20 27 467, SU-PS 190 211, DE-A-22 05 146, EP-A-49 504 oder DE-A 27 36 058).

In der US-PS 3 796 578 sind photopolymerisierbare Gemische aus Veresterungsprodukten von carboxylgruppenhaltigen Copolymerisaten mit ethylenisch ungesättigten Verbindungen, die einen Oxiranring tragen, einer ethylenisch ungesättigten Verbindung und einem Photopolymerisationsinitiator sowie deren Verwendung zur Herstellung von Offset-Druckplatten beschrieben. Die Verträglichkeit dieser Produkte ist jedoch noch verbesserungsbedürftig.

Ferner ist es bereits bekannt, zur Herstellung von photopolymeren Druck- oder Reliefformen photopolymerisierbare Gemische einzusetzen, die neben photopolymerisierbaren Monomeren, mindestens einem Photoinitiator sowie gegebenenfalls weiteren Zusatz- und/oder Hilfsstoffen als polymere Bindemittel Vinylpyrrolidon-Polymerisate, wie z.B. Polyvinylpyrrolidon oder Vinylpyrrolidon/Vinylacetat-Copolymerisate, enthalten (vgl. z.B. DE-A-17 97 373). Diese photopolymerisierbaren Gemische sind mit wäßrigen Lösungsmitteln, insbesondere reinem Wasser, entwickelbar.

Die bekannten, wäßrig-entwickelbaren lichtempfindlichen Aufzeichnungsmaterialien sind wohl bereits für viele Zwecke brauchbar und geeignet, lassen jedoch hinsichtlich einer Reihe ihrer Eigenschaften noch zu wünschen übrig. So sind sie im photopolymerisierten Zustand häufig zu empfindlich gegenüber dem Auswaschmedium, d.h. die Überwaschempfindlichkeit beim Entwickeln ist groß, oder zeigen die aus ihnen hergstellten Druckformen oder Resistmuster eine unzureichende Beständigkeit gegenüber den bei ihrer Anwendung zum Einsatz gelangenden wäßrigen Medien. Feine Bildelemente sind mit diesen Aufzeichnungsmaterialien vielfach nur schwer zu reproduzieren, und es müssen bei den Auswaschbedingungen sehr enge Grenzen bezüglich Auswaschzeit, Temperatur und Zusammensetzung der Entwicklerlösung eingehalten werden. Ferner kommt es bei den bekannten, wäßrig- alkalisch entwickelbaren Materialien leicht zu Restschicht-Bildungen bei der Entwicklung, d.h. die bei der bildmäßigen Belichtung nicht photopolymerisierten Anteile der Aufzeichnungsschicht lassen sich nicht restlos und einwandfrei vom Träger entfernen. Diese Erscheinung, die insbesondere bei Einsatz von metallischen Trägern oder Substraten für die photopolymerisierbare Aufzeichnungsschicht auftritt, ist vor allem bei der Herstellung von Resistmustern und Flachdruckplatten hinderlich und störend. Darüber hinaus zeigen die bisher bekannten polymeren Bindemittel für die wäßrig-alkalisch entwickelbaren photopolymerisierbaren Aufzeichnungsmaterialien nur eine begrenzte Verträglichkeit mit den üblichen, in diesen Aufzeichnungsmaterialien eingesetzten, photopolymerisierbaren Verbindungen, wodurch entweder die Einsatzbreite der photopolymerisierbaren Verbindungen beschränkt ist oder die Belichtungseigenschaften der photopolymerisierbaren Aufzeichnungsschichten für die Praxis nicht zufriedenstellend sind.

Aus der EP-A-0 152 889 ist ein lichtempfindliches Aufzeichnungsmaterial, insbesondere für die Herstellung von Flachdruckplatten oder Resistmustern, mit einer ein polymeres Bindemittel enthaltenden, wäßrig entwickelbaren, lichtempfindlichen Aufzeichnungsschicht bekannt, wobei in der lichtempfindlichen Aufzeichnungsschicht als polymeres Bindemittel ein in wäßrigen Medien, insbesondere wäßrig-alkalischen Medien, lösliches oder zumindest dispergierbares Copolymerisat enthalten ist, welches als Comonomeres ein Anhydrid einer polymerisierbaren, ethylenisch ungesättigten Monocarbonsäure, insbesondere Methacrylsäureanhydrid, in einer Menge von 0,05 bis 2 Gew.-%, bezogen auf das Copolymerisat, einpolymerisiert enthält.

In der älteren, nicht vorveröffentlichten EP-A-0 186 844 wird ein lichtempfindliches, zur Herstellung von Druckformnen oder Resistmustern geeignetes Aufzeichnungselement mit einer auf einem dimensionsstabilen Träger aufgebrachten, wäßrig-alkalisch entwickelbaren photopolymerisierbaren Aufzeichnungsschicht vorgeschlagen, die als polymeres Bindemittel ein in Wasser unlösliches, in wäßrig-alkalischen Lösungen jedoch lösliches oder zumindest dispergierbares, filmbildendes Copolymerisat aus 10 bis 50 Gew.-% mindestens eines N-Vinylamids, 5 bis 30 Gew.-% Acrylsäure und/oder Methacrylsäure sowie 30 bis 80 Gew.-% mindestens eines hydrophoben Comonomeren, welches als solches in Wasser und wäßrig-alkalischen Lösungen unlösliche Homopolymerisate bildet, enthält.

Aufgabe der vorliegenden Erfindung war es, neue lichtempfindliche Aufzeichnungselemente mit einer wäßrig-alkalisch entwickelbaren photopolymerisierbaren Aufzeichnungsschicht zu schaffen, die eine bessere Verträglichkeit aufweisen und für die Herstellung von photopolymeren Druckformen oder Resistmustern besser geeignet sind. Insbesondere war es Aufgabe der vorliegenden Erfindung, solche lichtempfindlichen Aufzeichnungselemente zu schaffen, die eine gute Entwickelbarkeit und einen möglichst großen Entwicklungsspielraum beim Auswaschen mit wäßrig-alkalischen Entwicklerlösungen aufweisen und gleichzeitig im belichteten Zustand eine hohe Beständigkeit gegenüber wäßrigen Medien, auch schwach alkalischen wäßrigen Lösungen, besitzen, ohne daß hierbei ihr allgemeines Eigenschafts profil negativ verändert wird. Die photopolymerisierbaren, wäßrig- alkalisch entwickelbaren Aufzeichnungsschichten sollen dabei insbesondere gegenüber metallischen Trägern oder Substraten eine gute Haftung aufweisen, ohne daß es jedoch bei der Verarbeitung zur Restschicht-Bildung kommt. Ganz allgemein sollen die neuen, wäßrig-alkalisch entwickelbaren lichtempfindlichen Aufzeichnungselemente gute verarbeitungs- und anwendungstechnische Eigenschaften, wie z.B. gute Belichtungseigenschaften, besitzen, die Wiedergabe auch von feinen Bildelementen exakt und sicher ermöglichen, sich für eine breite Anwendung eignen und sich für verschiedene Anwendungszwecke einfach und leicht optimal einstellen lassen.

Es wurde nun überraschenderweise gefunden, daß diese Aufgabe durch lichtempfindliche Aufzeichnungselemente mit einer auf einem dimensionsstabilen Träger aufgebrachten, wäßrig-alkalisch entwickelbaren, photopolymerisierbaren Aufzeichnungsschicht gelöst wird, wenn die photopolymerisierbare Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat enthält, welches aus 10 bis 50 Gew.%, mindestens eines N-Vinylamids, 8 bis 30 Gew.% an Acrylsäure und/oder Methacrylsäure sowie 30 bis 80 Gew.% mindestens eines hydrophoben Comonomeren, welches als solches in Wasser und wäßrig-alkalischen Lösungen unlösliche Homopolymerisate bildet, in einpolymerisierter Form besteht und die Carboxylgruppen des Copolymerisats teilweise durch Umsetzung mit Glycidylacrylat oder Glycidylmethacrylat verestert sind.

Gegenstand der Erfindung ist dementsprechend ein zur Herstellung von photopolymeren Druckformen oder Resistmustern geeignetes, lichtempfindliches Aufzeichnungselement mit einer auf einem dimensionsstabilen Träger aufgebrachten, wäßrigen-alkalisch entwickelbaren, ein polymeres Bindemittel enthaltenden photopolymerisierbaren Aufzeichnungsschicht, als polymeres Bindemittel mindestens ein in Wasser unlösliches, in wäßrig-alkalischen Lösungen jedoch lösliches oder zumindest dispergierbares, filmbildendes Copolymerisat aus N-Vinylamid, Acrylsäure und/oder Methacrylsäure sowie mindestens einem hydrophoben Comonomeren, welches als solches in Wasser und wäßrig-alkalischen Lösungen unlösliche Homopolymerisate bildet, enthält, dadurch gekennzeichnet, daß das Copolymerisat aus 10 bis 50 Gew.% mindestens eines N-Vinylamids, 8 bis 30 Gew.% Acrylsäure und/oder Methacrylsäure sowie 30 bis 80 Gew.% des hydrophoben Comonomeren, besteht, mit der Maßgabe, daß die Carboxylgruppen des Copolymerisats teilweise durch Umsetzung mit Glycidylacrylat oder Glycidylmethacrylat verestert sind.

Das polymere Bindemittel enthält also (a) 10 bis 50 Gew.% mindestens eines N-Vinylamids, (b) 8 bis 30 Gew.% Acrylsäure und/oder Methacrylsäure sowie (c) 30 bis 80 Gew.% mindestens eines hydrophoben Comonomeren welches als solches in Wasser und wäßrig-alkalischen Lösungen unlösliche Homopolymerisate bildet, einpolymerisiert, wobei die Summe der unter (a) bis (c) genannten Prozentzahlen 100 ist, mit der Maßgabe, daß ein Teil der Carboxylgruppen des Copolymerisats, vorzugsweise 10 bis 60% der Carboxylgruppen durch Umsetzung mit Glycidylacrylat oder Glycidylmethacrylat verestert sind.

Durch den erfindungsgemäßen Einsatz der speziellen N-Vinylamid-Copolymerisate als polymeres Bindemittel in den photopolymerisierbaren Aufzeichnungsschichten werden lichtempfindliche Aufzeichnungselemente mit sehr vorteilhaften Eigenschaften erhalten. Besonders geeignet sind solche Aufzeichnungselemente, bei denen 10 bis 60% der Carboxylgruppen des Copolymerisats mit Glycidyl(meth)acrylat verestert sind, bzw. solche, deren mit Glycidyl(meth)acrylat teilweise veresterten Copolymerisate Säurezahlen von 20 bis 100 mg KOH/g aufweisen. Durch die gute Verträglichkeit der erfindungsgemäß einzusetzenden Copolymerisate mit photopolymerisierbaren Monomeren und Oligomeren läßt sich in den photopolymerisierbaren Aufzeichnungsschichten eine breite Vielfalt solcher auch mehrfunktioneller, photopolymerisierbarer Monomerer und/oder Oligomerer selbst in großen Mengen einsetzen. Dadurch läßt sich das Eigenschaftsbild der mit den erfindungsgemäßen Aufzeichnungselementen hergestellten Druckformen oder Resistmuster einfach und leicht variieren. Trotz einer guten Entwickelbarkeit in rein wäßrig-alkalischen Entwicklerlösungen zeigen die Aufzeichnungsmaterialien im photopolymerisierten Zustand eine hohe Beständigkeit gegenüber wäßrigen Medien, wie sie beispielsweise bei der Verwendung von Druckformen und insbesondere auch bei Einsatz von Resistmustern in der Ätz- oder Galvanotechnik zur Anwendung kommen. Die erfindungsgemäßen lichtempfindlichen Aufzeichnungselemente zeigen eine geringe Überwaschempfindlichkeit, die photopolymerisierbare Aufzeichnungsschicht ist auch auf metallischen Trägern oder Substraten stabil bei gleichzeitig guter Haftung zu diesen Trägern bzw. Substraten, und sie erlauben die exakte und sichere Reproduktion auch von feinen Bildelementen, beispielsweise Linien von 100 µm Breite oder darunter. Die lichtempfindlichen Aufzeichnungselemente können wegen der guten Haftungsdifferenzierung der erfindungsgemäßen photopolymerisierbaren Aufzeichnungsschichten auch mit Vorteil als Trockenfilmresist für die trockene Schichtübertragung eingesetzt werden.

Bei den erfindungsgemäß in der photopolymerisierbaren Aufzeichnungsschicht der lichtempfindlichen Aufzeichnungselemente enthaltenen polymeren Bindemitteln handelt es sich um carboxylgruppenhaltige N-Vinylamid-Copolymerisate, deren Carboxylgruppen teilweise mit Glycidylacrylat oder Glycidylmethacrylat verestert sind und die in reinem Wasser unlöslich, in wäßrig-alkalischen Lösungen jedoch löslich oder zumindest dispergierbar sind. Bevorzugt sind die derart modifizierten N-Vinylamid-Copolymerisate in wäßrig-alkalischen Lösungen mit einem pH-Wert größer als 9, insbesondere im Bereich von 9 bis 13, löslich oder zumindest dispergierbar, in wäßrig-alkalischen Lösungen mit pH-Werten unter 9 jedoch unlöslich. Die erfindungsgemäß einzusetzenden Copolymerisate sollen darüberhinaus filmbildend sein und haben im allgemeinen ein mittleres Molekulargewicht (Gewichtsmittel) größer 10.000, vorzugsweise im Bereich von 15.000 bis 500.000, insbesondere im Bereich von 20.000 bis 250.000.

Die erfindungsgemäß einzusetzenden, durch teilweise Veresterung der Carboxylgruppen mit Glycidyl-(meth)acrylat erhaltenen Copolymerisate werden üblicherweise erhalten durch Copolymerisation von N-Vinylamiden, Acryl und/oder Methacrylsäure sowie hydrophoben Comonomeren, welche als solche in Wasser und in wäßrig-alkalischen Lösungen unlösliche Homopolymerisate bilden, und Veresterung eines Teiles der Carboxylgruppen des Copolymerisats durch Glycidylacrylat oder Glycidylmethacrylat.

Als vorteilhaft haben sich unter den hydrophoben Comonomeren diejenigen erwiesen, die als solche Homopolymerisate mit einer Glasübergangstemperatur (gemessen nach der DSC-Methode) über 300°K, insbesondere über 320°K, zu bilden vermögen. Die Comonomeren für die Herstellung der erfindungsgemäß einzusetzenden Copolymerisate sollen selbstverständlich miteinander copolymerisierbar sein.

Als N-Vinylamide kommen beispielsweise die N-Vinyl-Derivate von aliphatischen Carbonsäureamiden in Betracht, wie z.B. N-Vinylformamid, N-Vinylacetamid oder N-Vinyl-N-Methylacetamid. Bevorzugt enthalten die erfindungsgemäß einzusetzenden Copolymerisate als N-Vinylamid-Comonomere N-Vinyllactame, insbesondere N-Vinylpyrrolidon und/oder N-Vinylcaprolactam, einpolymerisiert. Die Copolymerisate können ein oder mehrere der N-Vinylamid-Comonomeren einpolymerisiert enthalten, wobei der Anteil der in dem Copolymerisat einpolymerisierten N-Vinylamid-Comonomereinheiten im Bereich von 10 bis 50 Gew.%, vorzugsweise im Bereich von 20 bis 45 Gew.%, bezogen auf das Copolymerisat, liegt.

Als zweite Gruppe von Comonomeren enthält das Copolymerisat Acrylsäure und/oder Methacrylsäure in einer Menge von 8 bis 30 Gew.%, insbesondere in einer Menge von 10 bis 25 Gew.%, bezogen auf das Copolymerisat, einpolymerisiert.

Als Beispiele für die hydrophoben Comonomeren, die im Copolymerisat als dritter Bestandteil einpolymerisiert enthalten sind, seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol, p-Methylstyrol und dergleichen, Vinylacetat sowie die Ester der Acrylsäure und Methacrylsäure, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere der hydrophoben Comonomeren einpolymerisiert enthalten, wobei der Anteil der hydrophoben Comonomer-Einheiten in dem Copolymerisat 30 bis 80 Gew.%, vorzugsweise 40 bis 70 Gew.%, bezogen auf das Copolymerisat, beträgt.

Beispiele für Copolymerisate, die sich nach teilweiser Veresterung der Carboxylgruppen mit Glycidyl(meth)acrylat für den erfindungsgemäßen Einsatz als polymeres Bindemittel in den photopolymerisierbaren Aufzeichnungsschichten der lichtempfindlichen Aufzeichnungselemente als besonders vorteilhaft erwiesen haben, sind u.a. N-Vinyllactam/(Meth)acrylsäure/Methylmethacrylat-Copolymerisate oder N-Vinyllactam/(Meth)acrylsäure/Styrol-Copolymerisate. In einer typischen Ausführungsform enthalten diese Copolymerisate die Comonomeren beispielsweise in Mengen von 25 bis 35 Gew.% an N-Vinylcaprolactam und/oder N-Vinylpyrrolidon, 10 bis 15 Gew.% an (Meth)acrylsäure und 55 bis 65 Gew.% an den hydrophoben Comonomeren, jeweils bezogen auf das Copolymerisat, einpolymerisiert.

Die Comonomeren für die erfindungsgemäß einzusetzenden Copolymerisate werden nach Art und Menge in dem vorstehend angegebenen allgemeinen Rahmen so ausgewählt, daß die Copolymerisate nach teilweiser, vorzugsweise 10 bis 60%iger Veresterung der Carboxylgruppen mit Glycidyl(meth)acrylat filmbildend sind und die an sie gestellten Forderungen bezüglich ihrer Löslichkeit bzw. Dispergierbarkeit erfüllen. Die Grenzen für den Anteil der einzelnen Comonomer-Gruppen sind dabei im Hinblick auf die allgemeinen Eigenschaften der Copolymerisate und speziell der hiermit hergestellten erfindungsgemäßen lichtempfindlichen Aufzeichnungselemente von Bedeutung. Liegt der Gehalt der einzelnen Comonomeren in den Copolymerisaten sowie ihr Veresterungsgrad mit Glycidyl(meth)acrylat außerhalb dieser Grenzen, so werden die Eigenschaften der erfindungsgemäßen lichtempfindlichen Aufzeichnungselemente bzw. die der hieraus hergestellten Druckformen oder Resistmuster nachteilig beeinflußt.

Vorzugsweise weisen die erfindungsgemäßen mit Glycidyl(meth)acrylat teilweise veresterten Copolymerisate Säurezahlen von 20 bis 100 mg KOH/g auf.

Die erfindungsgemäß als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. nie dere Alkanole, Ketone oder Ester, wie Methanol, Aceton, Methylethylketon oder Ethylacetat, als Lösungsmittel. Als Polymerisationsinitiatoren kommen die üblichen radikalischen Starter, wie beispielsweise Azobisisobutyronitril, Benzoylperoxid und dergleichen, in Betracht.

Die Veresterung mit Glycidylacrylat und/oder Glycidylmethacrylat kann in üblicher Weise durch Umsetzung der carboxylgruppenhaltigen Copolymerisate mit Glycidyl(meth)acrylat in Lösung bei 70 bis 110°C erfolgen.

Zweckmäßigerweise kann die Funktionalisierung der carboxylgruppenhaltigen Copolymerisate mit Glycidyl(meth)acrylat folgendermaßen erfolgen : 10-20%ige Lösungen der carboxylgruppenhaltigen Copolymerisate in Diethylenglycoldimethylether werden vorgelegt und bei 110°C eine Lösung bestehend aus 30 Teilen Glycidyl(meth)acrylat, 2 Teilen thermischem Inhibitor (z.B. Xyligen® Al) und 2 Teilen Katalysator (z.B. Dimethylaminopyridin, N-Methylimidazol oder Tetrabutylammoniumiodid) innerhalb von 2 Stunden zugetropft. Die Reaktion ist üblicherweise nach 3,5 Stunden beendet. Die kalte Reaktionsmischung kann dann auf 1-5% Feststoffgehalt verdünnt und in Wasser ausgefällt werden.

Je nach Umsatz der Carboxylgruppen des Copolymerisats lassen sich gezielt Bindemittel mit verschiedenen Säurezahlen (SZ) herstellen. Dies hat den Vorteil, daß das Bindemittel ohne Schwierigkeiten auf den pH-Bereich des Entwicklers eingestellt werden kann (z.B. SZ 90, entwickelbar in pH 11 ; SZ 25, entwickelbar in pH 12,5).

In der photopolymerisierbaren Aufzeichnungsschicht der erfindungsgemäßen lichtempfindlichen Aufzeichnungselemente können ein oder mehrere N-Vinylamid-Copolymerisate der in Rede stehenden Art als polymeres Bindemittel enthalten sein. Neben dem polymeren Bindemittel enthält die photopolymerisierbare Aufzeichnungsschicht im allgemeinen mindestens eine ethylenisch ungesättigte, photopolymerisierbare Verbindung, mindestens einen Photopolymerisationsinitiator bzw. ein Photopolymerisationsinitiatorsystem sowie gegebenenfalls weitere Zusatz-und/oder Hilfsstoffe zur Verbesserung und/oder Modifizierung der allgemeinen Eigenschaften der lichtempfindlichen Aufzeichnungselemente bzw. der hieraus hergestellten Druckformen oder Resistmuster.

Als ethylenisch ungesättigte, photopolymerisierbare Verbindungen kommen dabei sowohl Monomere als auch ethylenisch ungesättigte, photopolymerisierbare Oligomere in Betracht. Die Monomeren haben ein Molekulargewicht unter 1.000. Das mittlere Molekulargewicht (Zahlen-er. mittel) der photopolymerisierbaren Oligomeren liegt vorzugsweise im Bereich von 1.000 bis 10.000, insbesondere von 1.500 bis 6.000. Die photopolymerisierbaren Monomeren und Oligomeren können dabei sowohl mono- als auch polyfunktionell sein, d.h. eine oder mehrere photopolymerisierbare, ethylenische Doppelbindungen besitzen. Üblicherweise sind in der photopolymerisierbaren Aufzeichnungsschicht bi- oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten. Wegen der guten Verträglichkeit der erfindungsgemäß als polymeres Bindemittel einzusetzenden speziellen N-Vinylamid-Copolymerisate kommen als photopolymerisierbare Verbindungen in den erfindungsgemäßen lichtempfindlichen Aufzeichnungselementen eine große Vielzahl von Monomeren und Oligomeren in Betracht, die allein oder in Mischung miteinander eingesetzt werden können.

Als Vertreter für die photopolymerisierbaren Monomeren seien insbesondere die Derivate der (Meth)acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis 500, 1,2-Propandiol, 1,3-Propandiol, Polypropylenglykolen mit einem Molekulargewicht bis 500, 1,4-Butandiol, 1,1,1-Trimethylolpropan, 2,2-Dimethylpropandiol, Glycerin oder Pentaerythrit ; Pentaerythrittetra-(meth)acrylat, Glucosetri- oder tetra-(meth)acrylat, ferner die Monoacrylate und Monomethacrylate der genannten Diole und Polyole, wie z.B. Ethylenglykol-, Di-, Tri- oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure oder Glyoxalbisamid.

Sehr geeignete ethylenisch ungesättigte, photopolymerisierbare Verbindungen für die erfindungsgemäßen lichtempfindlichen Aufzeichnungselemente sind auch die monomeren Urethanacrylate bzw. -methacrylate mit zwei oder mehr Acryloyl- und/oder Methacryloyl-Gruppen. Solche monomeren Urethan-(meth)acrylate können beispielsweise erhalten werden durch Umsetzung von aliphatischen Di- oder Polyolen mit organischen Diisocyanaten in einem Äquivalentverhältnis OH : NCO von 1 : 2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- oder Polyole kommen unter anderem die vorstehend im Zusammenhang mit den Di- und Tri(meth)acrylaten genannten Di- und Polyhydroxy-Verbindungen in Betracht ; als Beispiele für organische Diisocyanate seien Hexamethylendiisocyanat, Toluylendiisocyanat, Isophorondiisocyanat und ähnliche genannt ; Hydroxyalkyl(meth)acrylate sind beispielsweise Hydroxyethyl-(meth)acrylat, Propandiol-mono(meth)acrylat oder Butandiol-mono(meth)acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure. Als Di- und Polyglycidylverbindungen kommen hier insbesondere die Di- und Polyglycidylether mehrwertiger Phenole, beispielsweise des Bisphenols A oder der Substitutionsprodukte von Bisphenol A, in Betracht. Beispielhaft für solche Acryloyl-und/oder Methacryloyl-Gruppen enthaltenden Monomeren seien die Umsetzungsprodukte des Bisphenol A-bisglycidylethers mit Acryl- und/oder Methacrylsäure im molaren Verhältnis von 1 : 2 hervorgehoben.

Als besonders vorteilhaft, insbesondere für die Herstellung von Resistmustern, hat es sich erwiesen, wenn die lichtempfindlichen Aufzeichnungselemente in der photopolymerisierbaren Aufzeichnungsschicht als photopolymerisierbare Verbindung Oligomere mit 2 oder vorzugsweise mehr als 2 Acryloyl- und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind. Von besonderem Interesse sind hierbei solche Oligomeren der in Rede stehenden Art, die neben den Acryloyl- und/oder Methacryloyl-Gruppen zusätzlich noch freie Carboxylgruppen im Molekül enthalten. Der Anteil der freien Carboxyl-Gruppen in diesen photopolymerisierbaren Oligomeren liegt dabei vorteilhafterweise so hoch, daß die Oligomeren eine Säurezahl im Bereich von 50 bis 150 mg KOH/g aufweisen. Geeignete photopolymerisierbare Oligomere dieser Art, wie sie auch in den erfindungsgemäßen lichtempfindlichen Aufzeichnungselementen enthalten sein können, sind z.B. in der DE-A-24 42 527, der DE-C-25 57 408 oder auch der DE-A-29 17 483 beschrieben. Weitere photopolymerisierbare Oligomere, deren Einsatz in den erfindungsgemäßen lichtempfindlichen Aufzeichnungselementen zu besonders günstigen Ergebnissen geführt hat, können beispielsweise hergestellt werden, indem man die Hydroxylgruppen einer Acryloyl- und/oder Methacryloyl-Gruppen enthaltenden Diol- oder Polyol-Verbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxyl gruppen des so erhaltenen Reaktionsprodukts unter Kettenverlängerung sowie gegebenenfalls Verzweigung mit Di- und/oder Polyepoxiden umsetzt. Die Acryloyl-und/oder Methacryloyl-Gruppen enthaltenden Diol-oder Polyol-Verbindungen, die als Ausgangsprodukt für die Herstellung solcher Oligomerer dienen, werden zweckmäßigerweise hergestellt, indem man Di-oder Polyepoxid-Verbindungen, wie z.B. Di- oder Polyglycidylether bzw. Di- oder Polyglycidylester mit Acrylsäure und/oder Methacrylsäure im Äquivalentverhältnis Glycidyl-Gruppen : COOH-Gruppen von 1: 1 umsetzt. Die Di- oder Polyepoxid-Verbindungen können dabei auch beispielsweise vor oder während der Umsetzung mit der (Meth)acrylsäure durch Umsetzung mit Dicarbonsäuren vorverlängert werden. Beispielhaft und stellvertretend für Oligomere der letztgenannten Art seien die Produkte genannt, wie sie erhältlich sind durch Umsetzung von Bisphenol A-bisglycidylether mit Acryl- und/oder Methacrylsäure bzw. mit einem Gemisch aus 30 bis 70 Mol.% einer Dicarbonsäure, beispielsweise Adipinsäure, und 30 bis 70 Mol.% Acryl- und/oder Methacrylsäure im Äquivalentverhältnis Glycidyl-Gruppen : Gesamt-COOH von 1 : 1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen: Anhydrid-Gruppen von 1 : 1 unter Bildung der sauren Teilester der mehrfachen Carbonsäuren und schließlich Umsetzung eines Teils der freien Carboxyl-Guppen des so erhaltenen Reaktionsproduktes mit einem Di- und/oder Polyglycidylether, beispielsweise Bisphenol A-bisglycidylether oder Pentaerythrittriglycidylether, im Äquivalentverhältnis COOH-Gruppen : Glycidyl-Gruppen von größer 1 : 1, vorzugsweise im Bereich von 1,15 : 1 bis 5 : 1.

Die ethylenisch ungesättigten, photopolymerisierbaren Monomeren und/oder Oligomeren werden dabei – für den Fachmann selbstverständlich – so gewählt, daß sie mit den als polymerem Bindemittel eingesetzten N-Vinylamid-Copolymerisaten verträglich sind. Das Mengenverhältnis von polymerem Bindemittel zu den ethylenisch ungesättigten, photopolymerisierbaren Verbindungen in der photopolymerisierbaren Aufzeichnungsschicht der erfindungsgemäßen lichtempfindlichen Aufzeichnungselemente kann in weiten Grenzen variiert werden und beispielsweise im Bereich von 1: 99 bis 90 : 10 liegen. Ein niedriger Anteil an polymerem Bindemittel, beispielsweise im Bereich von 1 bis 35 Gew.%, bezogen auf die photopolymerisierbare Aufzeichnungsschicht, kommt insbesondere dann in Betracht, wenn in der photopolymerisierbaren Aufzeichnungsschicht als ethylenisch ungesättigte, photopolymerisierbare Verbindung ein hoher Anteil, beispielsweise 40 Gew.% oder mehr und insbesondere mehr als 45 Gew.%, bezogen auf die photopolymerisierbare Aufzeichnungsschicht, an einem oder mehreren, mehr als zwei Acryloyl- und/oder Methacryloyl-Gruppen sowie freie Carboxyl-Gruppen enthaltenden Oligomeren enthalten ist.

Als Photoinitiatoren für die photopolymerisierbaren Aufzeichnungsschichten kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z.B. α-Methylbenzoinalkylether oder α-Hydroxymethylbenzoinalkylether ; Benzile, Benzilketale, insbesondere Benzildimethylketal, Benzilmethylethylketal oder Benzilmethylbenzylketal ; die als Photoinitiator bekannten und wirksamen Acylphosphinoxid-Verbindungen, wie z.B. 2,4,6-Trimethylbenzoyldiarylphosphinoxid ; Benzophenon, Derivate des Benzophenons, 4,4'-Dimethylaminobenzophenon, 4,4'-Diethylaminobenzophenon, Derivate von Michler's Keton ; Anthrachinon und substituierte Anthrachinone ; arylsubstituierte Imidazole oder deren Derivate, wie z.B. 2,4,5-Triarylimidazoldimere ; 2-Chlorthioxanthon und die als Photoinitiatoren wirksamen Acridin- oder Phenacin-Derivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michler's Keton ; oder Gemische aus 2,4,5-Triarylimidazol-Dimeren und 2-Mercaptobenzochinazol oder den Leukobasen von Triphenylmethanfarbstoffen. Die Auswahl der geeigneten Photoinitiatoren bzw. Photoinitiator-Systeme ist dem Fachmann geläufig. Die Photoinitiatoren bzw. Photoinitiatorsysteme sind in der photopolymerisierbaren Aufzeichnungsschicht in Mengen von 0,001 bis 10 Gew.%, vorzugsweise in Mengen von 0,05 bis 5 Gew.%, bezogen auf die photopolymerisierbare Aufzeichnungsschicht, enthalten.

Als weitere Zusatz- und/oder Hilfsstoffe, die in der photopolymerisierbaren Aufzeichnungsschicht der erfindungsgemäßen lichtempfindlichen Aufzeichnungselemente enthalten sein können, kommen z.B. thermische Polymerisationsinhibitoren, Farbstoffe und/oder Pigmente, photochrome Verbindungen bzw. Systeme, sensitometrische Regler, Weichmacher, Verlaufshilfsmittel, Mattierungs- oder Gleitmittel und dergleichen in Betracht. Geeignete thermische Polymerisationsinhibitoren sind z.B. Hydrochinon, Hydrochinon-Derivate, 2,6-Di-t.-butyl-p-cresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, Naphthalimidfarbstoffe und 3'-Phenyl-7-dimethylamino-2,2'-spiro-di-(2H-1-benzopyran). Photochrome Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt ; ferner kommt auch Rhodamin B-Base in Betracht. Als Aktivatoren für diese photochromen Verbindungen kommen u.a. organische Halogenverbindungen, die bei Belichtung mit aktinischem Licht Halogenradikale abspalten, oder Hexaarylbisimidazole in Betracht. Zu den sensitometrischen Reglern gehören Verbindungen wie z.B. 9-Nitroanthracen, 10,10'-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Aufzeichnungsschichten in den für diese Stoffe üblichen und bekannten wirksamen Mengen vorhanden. Ihre Menge sollte jedoch 30 Gew.%, vorzugsweise 20 Gew.%, bezogen auf die photopolymerisierbare Aufzeichnungsschicht, nicht überschreiten.

Das Mischungsverhältnis, in dem die einzelnen Komponenten in der photopolymerisierbaren Aufzeichnungsschicht enthalten sind, wird so gewählt, daß diese Aufzeichnungsschicht nicht nur wäßrigalkalisch entwickelbar, sondern vorteilhafterweise auch bei Raumtemperatur fest und nicht klebrig ist und gute Filmbildungseigenschaften besitzt. Für den Einsatz der erfindungsgemäßen lichtempfindlichen Aufzeichnungselemente als Photoresistfilm wird die Zusammensetzung darüber hinaus so gewählt, daß die photopolymerisierbare Aufzeichnungsschicht gut laminierbar und unter Anwendung von Druck sowie gegebenenfalls Wärme auf ein Substrat übertragbar ist. Die Dicke der photopolymerisierbaren Aufzeichnungsschicht richtet sich bekanntermaßen nach dem Anwendungszweck der lichtempfindlichen Aufzeichnungselemente und kann daher in weiten Grenzen schwanken. Für die Herstellung von Hochdruck- oder Tiefdruckformen liegt die Dicke der photopolymerisierbaren Aufzeichnungsschicht im Bereich von 100 µm bis zu einigen mm ; für die Herstellung von Resistmustern werden üblicherweise Schichtdicken der photopolymerisierbaren Aufzeichnungsschicht im Bereich von 1 bis 50 µm eingestellt ; für Flachdruckplatten liegt die Dicke der photopolymerisierbaren Aufzeichnungsschicht im allgemeinen im Bereich von 0,5 bis 6 µm.

In einer typischen Ausführungsform der Erfindung besteht die photopolymerisierbare Aufzeichnungsschicht der lichtempfindlichen Aufzeichnungselemente aus einer homogenen, filmbildenden und in wäßrig-alkalischen Lösungen löslichen oder zumindest dispergierbaren Mischung von

　　a) 40 bis 90, vorzugsweise 45 bis 85 Gew.% mindestens eines mit Glycidyl(meth)acrylat teilweise veresterten carboxylgruppenhaltigen N-Vinylamid-Copolymerisats der vorstehend genannten Art als polymerem Bindemittel,

　　b) 5 bis 55, vorzugsweise 5 bis 45 Gew.% mindestens eines ethylenisch ungesättigten, photopolymerisierbaren, mit dem bzw. den polymeren Bindemitteln verträglichen Monomeren, bei hohen Monomer-Gehalten gegebenenfalls auch in Mischung zusammen mit einer untergeordneten Menge an einem oder mehreren, verträglichen, photopolymerisierbaren Oligomeren,

　　c) 0,001 bis 10, vorzugsweise 3 bis 7 Gew.% mindestens eines Photopolymerisationsinitiators sowie

　　d) 0 bis 30 Gew.%, vorzugsweise 0,05 bis 20 Gew.%, an weiteren, die allgemeinen Eigenschaften der Aufzeichnungselemente bzw. der hieraus hergestellten Druckformen oder Resistmuster verbessernden bzw. modifizierenden Zusatz- und/oder Hilfsstoffen, wie Sensibilisatoren, beispielsweise in Mengen von 1 bis 4 Gew.%, Farbstoffe, beispielsweise in Mengen von 0,5 bis 3 Gew.%, sowie übliche Weichmacher, beispielsweise in Mengen von 0,5 bis 5, insbesondere 1 bis 3 Gew.%.

Wie vorstehend bereits erwähnt wurde, können die photopolymerisierbaren Aufzeichnungsschichten jedoch auch weniger als 40 Gew.%, beispielsweise nur 1 bis 35 Gew.%, bezogen auf die photopolymerisierbare Aufzeichnungsschicht, des oder der polymeren Bindemittel enthalten. In diesem Fall enthält die photopolymerisierbare Aufzeichnungsschicht, neben Photoinitiator sowie gegebenenfalls weiteren Zusatzund/oder Hilfsstoffen, mindestens 40 Gew.%, vorzugsweise 45 bis 75 Gew.%, bezogen auf die photopolymerisierbare Aufzeichnungsschicht, an einem oder mehreren, in wäßrig-alkalischen Lösungen löslichen oder zumindest dispergierbaren Oligomeren mit mehr als zwei ethylenischen, photopolymerisierbaren Doppelbindungen, insbesondere Acryloyl- und/oder Methacryloyl-Gruppen, sowie vorzugsweise freien Carboxyl-Gruppen und mit einem mittleren Molekulargewicht (Zahlenmittel) im Bereich von 1000 bis 10.000. Neben den photopolymerisierbaren Oligomeren kann die photopolymerisierbare Aufzeichnungsschicht in diesen Fällen auch noch photopolymerisierbare Monomere, insbesondere in einer Menge von 1 bis 30 Gew.%, vorzugsweise von 10 bis 25 Gew.%, bezogen auf die photopolymerisierbare Aufzeichnungsschicht, enthalten. Solche photopolymerisierbaren Aufzeichnungsschichten mit einem sehr geringen Anteil an polymerem Bindemittel eignen sich insbesondere für dünne Schichten, wie sie beispielsweise bei der Herstellung von Resistmustern und Photoresistfilmen zur Anwendung kommen.

Als Träger für die photopolymerisierbaren Aufzeichnungsschichten kommen die für lichtempfindliche Aufzeichnungselemente der in Rede stehenden Art üblichen und an sich bekannten dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So kommen für die Herstellung von Druckplatten als dimensionsstabile Träger insbesondere Kunststoff-Filme oder -Folien, z.B. aus Polyestern, sowie metallische Schichtträger, beispielsweise aus Stahl oder Aluminium, in Betracht. Für Photoresistfilme und Schichtübertragungsmaterialien finden als Trägermaterialien vorzugsweise Kunststoff- Filme oder -Folien, insbesondere Polyester-Folien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser – vor oder nach der Belichtung mit aktinischem Licht – abgezogen werden können. Für die Herstellung von Resistmustern kann die photopolymerisierbare Aufzeichnungsschicht auch direkt auf das zu schützende sowie gegebenenfalls dauerhaft zu modifizierende Substrat aufgebracht werden, welches dann als Täger für die photopolymerisierbare Aufzeichnungsschicht fungiert. Als Substrate für Photoresistschichten kommen beispielsweise Kupferbleche, kupferkaschierte Basismaterialien, Keramiksubstrate, die mit metallischen oder metalloxidischen Schichten beschichtet sind, Halbleiterelemente und Silicium-Wafer in Betracht. Die Trägermaterialien für die photopolymerisierbaren Aufzeichnungsschichten können gegebenenfalls in an sich bekannter Weise, z.B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch eine oder mehrere Zwischenschichten angeordnet sein. Bei lichtempfindlichen Aufzeichnungselementen für die Herstellung von Druckformen, insbesondere Hochdruck- oder Tiefdruckformen, können diese Zwischenschichten als Haftschicht und/oder Lichthofschutzschicht ausgebildet sein. Bei Photoresistfilmen und Schichtübertragungsmaterialien kann eine solche Zwischenschicht zwischen photopolymerisierbarer Aufzeichnungsschicht und dem abziehbaren, temporären Schichtträger das Abziehen des Schichtträgers nach dem Auflaminieren bzw. Aufkaschieren der photopolymerisierbaren Aufzeichnungsschicht auf das Substrat erleichtern und/oder als Sauerstoffsperrschicht nach dem Abziehen des Schichtträgers dienen.

Ebenso kann auf der dem Träger abgewandten Oberfläche der photopolymerisierbaren Aufzeichnungsschicht auch noch eine Deckschicht oder Deckfolie angeordnet sein, die vorzugsweise in dem gleichen Entwickler-Lösungsmittel löslich ist wie die photopolymerisierbare Aufzeichnungsschicht, oder von dieser abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungselemente und gegebenenfalls auch als Sauerstoffsperre für die photopolymerisierbare Aufzeichnungsschicht. Als besonders geeignet haben sich z.B. Deckschichten aus Polyvinylalkoholen oder Polyvinylalkohol-Derivaten bzw. – insbesondere bei Photoresistfilmen – Deckfolien aus Polyolefinen, wie z.B. Polyethylen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den – gegebenenfalls mit einer Zwischenschicht versehenen – Träger erfolgen. Beispielsweise kann man die Komponenten der photopolymerisierbaren Aufzeichnungsschicht rein mechanisch in einer geeigneten Mischvorrichtung, z.B. einem Mischer oder Extruder, homogen vermischen und diese Mischung, beispielsweise durch Extrudieren, Kalandrieren oder Pressen, zu einer Schicht der gewünschten Dicke formen, die dann auf den Träger auflaminiert bzw. aufkaschiert wird. Vorteilhafterweise werden die lichtempfindlichen Aufzeichnungselemente jedoch hergestellt, indem man die Komponenten der photopolymerisierbaren Aufzeichnungsschicht in einem geeigneten Lösungsmittel oder Lösungsmittelgemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, Ethylacetat und ähnliche, sowie Mischungen hiervon. Anschließend kann auf die photopolymerisierbare Aufzeichnungsschicht gewünschtenfalls noch die Deckschicht oder Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht – bei Photoresistfilmen und Schichtübertragungsmaterialien nach der Schichtübertragung auf das zu schützende Substrat – bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser oder Argonlaser eignen. Die von den Lichtquellen emittierte Wellenlänge soll zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein.

Durch die bildmäßige Belichtung mit dem aktinischen Licht wird in den belichteten Bereichen der Aufzeichnungsschicht eine Photopolymerisation ausgelöst, die zu einer Vernetzung in den belichteten Schichtbereichen und damit zu einer Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einer wäßrig-alkalischen Entwicklerlösung entwickelt. Das Entwickeln kann durch Waschen, Sprühen, Reiben oder Bürsten erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrig-alkalische Lösungen in Betracht, die zur Einstellung des günstigsten pH-Wertes im Bereich von 8 bis 14, vorzugsweise im Bereich von 9 bis 13, alkalisch reagierende Substanzen, wie z.B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dergleichen, mitverwendet werden. Obwohl die erfindungsgemäßen Aufzeichnungselemente mit rein wäßrig-alkalischen Entwicklerlösungen ausgewaschen werden können, ist es selbstverständlich grundsätzlich möglich, wenn auch nicht erforderlich, daß die wäßrig-alkalischen Entwicklerlösungen auch noch geringe Zusätze an wasserlöslichen organischen Lösungsmitteln, wie z.B. aliphatischen Alkoholen, Aceton oder Tetrahydrofuran, enthalten.

Die erfindungsgemäßen lichtempfindlichen Aufzeichnungselemente zeichnen sich durch ihre guten Belichtungseigenschaften und gute Entwickelbarkeit in wäßrig-alkalischen Entwicklerlösungen aus, wodurch es möglich ist, auch sehr feine Bildelemente vorlagengetreu und sicher zu reproduzieren. Auf metallischen oder metalloxidischen Untergründen besitzen die erfindungsgemäßen photopolymerisierbaren Aufzeichnungsschichten eine hervor ragende Haftung, ohne daß es bei der Entwicklung der bildmäßig belichteten Aufzeichnungsschicht zur Ausbildung von Restschicht-Belägen in den ausgewaschenen Bereichen kommt. Ferner besitzen die Aufzeichnungselemente im belichteten, d.h. photovernetzten Zustand, eine sehr hohe Beständigkeit gegenüber wäßrigen Medien, wie sie beispielsweise bei der Verwendung von Druckformen oder Resistmustern zur Anwendung kommen. Die erfindungsgemäßen lichtempfindlichen Aufzeichnungsmaterialien eignen sich grundsätzlich für alle Anwendungsgebiete der Reprographie und optischen Informationsfixierung.

Die erfindungsgemäßen lichtempfindlichen Aufzeichnungselemente haben wesentlich verbesserte Lichtempfindlichkeit. Vorsensibilisierte Offset-Platten ohne PVAL-Schutzfilm haben dadurch z.T. schnellere Belichtungszeiten als es dem Stand der Technik entspricht.

Aufgrund der intermolekularen Vernetzung des Bindemittels erreicht man extreme Molekulargewichtszunahmen, was in verbesserter Standfestigkeit der Offset-Schicht zum Ausdruck kommt.

PVAl-Schutzfilm tragende photopolymere Offset-Schichten auf Basis der erfindungsgemäßen lichtempfindlichen Aufzeichnungselemente lassen sich mit Lasern beschreiben und eignen sich für die Computer to plate Herstellung von Druckplatten.

Die Erfindung wird durch die nachfolgenden Beispiele näher erläutert. Die in den Beispielen genannten Teile und Prozente beziehen sich, sofern nicht anders angegeben, auf das Gewicht.

Modifizierung eines carboxylgruppenhaltigen Copolymerisats mit Glycidyl(meth)acrylat :

In einem Reaktionsgefäß wird ein Copolymerisat (K-Wert nach Fikentscher : 27) aus 67,5% Methacrylsäuremethylester, 22,5% N-Vinylpyrrolidon und 10% Methacrylsäure in Diethylenglykoldimethylether gelöst, so daß eine Lösung von 15% Feststoffgehalt entsteht. Diese Lösung wird auf 110°C erhitzt und bei dieser Temperatur eine Lösung aus 30 Teilen Glycidylmethacrylat, 2 Teilen eines thermischen Inhibitors (z.B. Xyligen® Al) und 2 Teilen eines Veresterungskatalysators (z.B. Dimethylaminopyridin, N-Methylimidazol oder Tetrabutylammoniumiodid) innerhalb von 2 Stunden gleichmäßig zugetropft. Die Reaktion ist nach 3,5 Stunden beendet. Nach dem Abkühlen wird das resultierende Reaktionsgemisch auf 3% Feststoffgehalt verdünnt, in Wasser ausgefällt und das gefällte Copolymerisat bei 50°C unter Ölpumpenvakuum getrocknet. Das erhaltene Copolymerisat weist eine Säurezahl von 25 mg KOH/g auf.

Beispiel 1

59% des oben beschriebenen mit Glycidylmethacrylat modifizierten carboxylgruppenhaltigen Copolymerisats (SZ : 25)
30% Monomer (Diacrylat des 1,4-Butandioldiglycidylethers)
2% Michler's Keton
6% 2-(4'-Methoxynaphthyl-1')-4,6-bis-(trichlormethyl)-s-triazin

1% Bromphenolblau

2% Weichmacher (Benzolsulfosäure-n-butylamid)

wurden in Tetrahydrofuran zu einer 5%igen Lösung verarbeitet und die homogene Lösung mittels einer Rakelvorrichtung (Gießspalt 35 µm, Abzugsgeschwindigkeit 250 mm/Minute) auf elektrolytisch aufgerauhte und anodisch oxidierte Aluminiumträgerbleche, wie sie für die Flachdruckplatten typisch sind, aufgetragen. Nach jeweils 10-minütiger Trocknung bei 80°C resultierte eine photopolymerisierbare Schicht mit einer Trocken-schichtdicke von 2,5 µm (2,7 g/m²). Die so herstell-ten Flachdruckplatten (ohne Sauerstoffsperrschicht) verblieben zunächst für 6 Tage in einem verschlossenen Beutel. Danach wurden sie zur Ermittlung der erforderlichen Mindestbelichtungszeit durch einen FOGRA PMS-Teststreifen mit aktinischem Licht belichtet. Nach der Belichtung wurden die Platten mit einer wäßrig-alkalischen Entwicklerlösung (pH 12,5) in 50 Sekunden entwickelt.

Eigenschaften der Aufzeichnungselemente :
PVAl-frei :
Belichtungszeit : 25 Sekunden (mit 3 kW Hg-Brenner)
Auflösung : K-Wert (nach FOGRA) 10 µm
Farbumschlag : gut

## Beispiel 2

Beispiel 1 wurde wiederholt ; jedoch wurde auf die freie Oberfläche der photopolymerisierbaren Schicht der Flachdruckplatten unmittelbar nach der Trocknung eine Sauerstoffsperrschicht aus einem Polyvinylalkohol (Verseifungsgrad 98%) in einer Schichtdicke von 5 µm (6 g/m²) aufgebracht. Für diese Flachdruckplatten mit Sauerstoffsperrschicht wurde in gleicher Weise wie für die Platten ohne Sauerstoffsperrschicht die erforderliche Mindestbelichtungszeit und die erzielbare Auflösung durch bildmäßige Belichtung mit aktinischem Licht durch den FOGRA PMS-Teststreifen ermittelt.

Eigenschaften :
Belichtungszeit : 1 Sekunde
Auflösung : K-Wert (nach FOGRA) 15-20 µm
Farbumschlag : gering

## Beispiel 3

Es wurde wie in Beispiel 1 verfahren ; jedoch wurden anstatt 30% 20% Monomer und anstatt 59% Bindemittel 69% Bindemittel eingesetzt.

Eigenschaften :
Belichtungszeit : 45 Sekunden
Auflösung : K-Wert (nach FOGRA) 12 µm
Farbumschlag : gut

## Beispiel 4

Es wurde wie in Beispiel 2 beschrieben verfahren, jedoch wurden anstatt 30% des Diacrylats des 1,4-Butandioldiglycidylethers 40% Trimethylolpropantriacrylat, anstatt 59% Bindemittel 49% und anstatt Bromphenolblau Viktoriablau eingesetzt.

Eigenschaften des so erhaltenen Aufzeichnungselements :
Empfindlichkeit : 0,6 mJ cm$^{-2}$
Auflösung : K-Wert (nach FOGRA) 12 µm
Dieses Aufzeichnungselement eignet sich auch zur Laserbelichtung (351 nm, Argon$^+$-Laser).

## Ansprüche

### Patentsprüche für die Vertragsstaaten : BE, CH, DE, FR, GB, IT, LI, NL, SE

1. Lichtempfindliches, zur Herstellung von Druck-formen oder Resistmustern geeignetes Aufzeich-nungselement mit einer auf einem dimensionsstabilen Träger aufgebrachten, wäßrig-alkalisch entwickelbaren, ein polymeres Bindemittel enthaltenden, photopolymerisierbaren Aufzeichnungsschicht die als polymeres Bindemittel mindestens ein in Wasser unlösliches, in wäßrig-alkalischen Lösungen jedoch lösliches oder zumindest dispergierbares, filmbildendes Copolymerisat aus N-Vinylamid, Acrylsäure und/oder Methacrylsäure sowie mindestens einem hydrophoben Comonomeren, welches als solches in Wasser und wäßrig-alkalischen Lösungen unlösliche Homopolymerisate bildet, enthält, dadurch gekennzeichnet, daß das Copolymerisat aus 10 bis 50 Gew.-% mindestens eines N-Vinylamids, 8 bis 30 Gew.-% Acrylsäure und/oder Methacrylsäure sowie 30 bis 80 Gew.-% des hydrophoben Comonomeren besteht, mit der Maßgabe, daß die Carboxylgruppen des Copolymerisats teilweise durch Umsetzung mit Glycidyl(meth)acrylat verestert sind.

2. Lichtempfindliches Aufzeichnungselement nach Anspruch 1, dadurch gekennzeichnet, daß 10 bis 60% der Carboxylgruppen des Copolymerisats mit Glycidyl(meth)acrylat verestert sind.

3. Lichtempfindliches Aufzeichnungselement nach Anspruch 1, dadurch gekennzeichnet, daß das Copolymerisat eine Säurezahl von 20 bis 100 mg KOH/g aufweist.

4. Lichtempfindliches Aufzeichnungselement nach einem der Ansprüche 1 bis 3, dadurch gekennzeichnet, daß das Copolymerisat als N-Vinylamid-Comonomeres mindestens ein N-Vinyllactam einpolymerisiert enthält.

5. Lichtempfindliches Auzeichnungselement nach Anspruch 4, dadurch gekennzeichnet, daß das Copolymerisat als N-Vinyllactam N-Vinylpyrrolidon und/oder N-Vinylcaprolactam einpolymerisiert enthält.

6. Lichtempfindliches Aufzeichnungselement nach einem der Ansprüche 1 bis 5, dadurch gekennzeichnet, daß das Copolymerisat als hydrophobes Comonomer Styrol, kern-oder seitenkettensubstituierte Styrole, Vinylacetat, Alkylacrylate und/oder Alkylmethacrylate einpolymerisiert enthält.

**Patentansprüche für die Vertragsstaaten :
AT, ES**

1. Verfahren zur Herstellung eines lichtempfindlichen, zur Herstellung von Druckformen oder Resistmustern geeigneten Aufzeichnungselements mit einer auf einem dimensionsstabilen Träger aufgebrachten, wäßrigalkalisch entwickelbaren, ein polymeres Bindemittel, mindestens eine ethylenisch ungesättigte, photopolymerisierbare Verbindung, mindestens einen Photoinitiator sowie gegebenenfalls weitere Zusatz- und/oder Hilfsstoffe enthaltenden, photopolymerisierbaren Aufzeichnungsschicht, die als polymeres Bindemittel mindestens ein in Wasser unlösliches, in wäßrig-alkalischen Lösungen jedoch lösliches oder zumindest dispergierbares, filmbildendes Copolymerisat aus N-Vinylamid, Acrylsäure und/oder Methacrylsäure sowie mindestens einem hydrophoben Comonomeren, welches als solches in Wasser und wäßrig-alkalischen Lösungen unlösliche Homopolymerisate bildet, enthält, dadurch gekennzeichnet, daß ein Copolymerisat aus 10 bis 50 Gew.-% mindestens eines N-Vinylamids, 8 bis 30 Gew.-% Acrylsäure und/oder Methacrylsäure sowie 30 bis 80 Gew.-% des hydrophoben Comonomeren eingesetzt wird, mit der Maßgabe, daß die Carboxylgruppen des Copolymerisats teilweise durch Umsetzung mit Glycidyl(meth)acrylat verestert sind.

2. Verfahren nach Anspruch 1, dadurch gekennzeichnet, daß 10 bis 60% der Carboxylgruppen des Copolymerisats mit Glycidyl(meth)acrylat verestert worden sind.

3. Verfahren nach Anspruch 1, dadurch gekennzeichnet, daß ein Copolymerisat eingesetzt wird, das eine Säurezahl von 20 bis 100 mg KOH/g aufweist.

4. Verfahren nach einem der Ansprüche 1 bis 3, dadurch gekennzeichnet, daß in das Copolymerisat als N-Vinylamid mindestens ein N-Vinyllactam einpolymerisiert worden ist.

5. Verfahren nach Anspruch 4, dadurch gekennzeichnet, daß als N-Vinyllactam N-Vinylpyrrolidon und/oder N-Vinylcaprolactam einpolymerisiert worden sind.

6. Verfahren nach einem der Ansprüche 1 bis 5, dadurch gekennzeichnet, daß in das Copolymerisat als hydrophobes Comonomer Styrol, kern- oder seitenkettensubstituierte Styrole, Vinylacetat, Alkylacrylate und/oder Alkylmethacrylate einpolymerisiert worden sind.

7. Verfahren nach einem der Ansprüche 1 bis 6, dadurch gekennzeichnet, daß als polymeres Bindemittel ein N-Vinyllactam/(Meth)-acrylsäure/-Methylmethacrylat-Copolymerisat eingesetzt wird.

8. Verfahren nach einem der Ansprüche 1 bis 6, dadurch gekennzeichnet, daß als polymeres Bindemittel ein N-Vinyllactam/(Meth)acrylsäure/-Styrol-Copolymerisat, eingesetzt wird.

9. Verfahren nach einem der Ansprüche 1 bis 8, dadurch gekennzeichnet, daß zur Herstellung des Copolymerisats 20 bis 45 Gew.-% mindestens eines N-Vinylamids, 10 bis 40 Gew.-% Acrylsäure und/oder Methacrylsäure sowie 40 bis 70 Gew.-% des hydrophoben Comonomeren einpolymerisiert worden sind, wobei sich die angegebenen Prozente jeweils auf das Copolymerisat beziehen.

10. Verfahren nach einem der Ansprüche 1 bis 9, dadurch gekennzeichnet, daß als ethylenisch ungesättigte, photopolymerisierbare Verbindungen Monomere und/oder Oligomere mit zwei oder mehr Acryloyl- und/oder Methacryloyl-Gruppen eingesetzt werden.

11. Verfahren nach einem der Ansprüche 1 bis 10, dadurch gekennzeichnet, daß die polymeren Bindemittel und die ethylenisch ungesättigten, photopolymerisierbaren Verbindungen im Gewichtsverhältnis von 1 : 99 bis 90 : 10 eingesetzt werden.

**Claims**

**Claims for the contracting states : BE, CH, DE, FR, GB, IT, LI, NL, SE**

1. A photosensitive recording element which is suitable for the production of printing plates or resist images and has a photopolymerizable recording layer which is applied to a dimensionally stable substrate, can be developed in an aqueous alkaline medium and contains a polymeric binder, said recording element containing, as a polymeric binder, one or more film-forming copolymers of N-vinylamide, acrylic acid and/or methacrylic acid which are insoluble in water but soluble or dispersible in aqueous alkaline solutions and one or more hydrophobic comonomers which as such form homopolymers which are insoluble in water and aqueous alkaline solutions, wherein the copolymer consists of from 10 to 50% by weight of one or more N-vinylamides, from 8 to 30% by weight of acrylic acid and/or methacrylic acid and from 30 to 80% by weight of the hydrophobic comonomer, with the proviso that some of the carboxyl groups of the copolymer are esterified by reaction with glycidyl (meth)acrylate.

2. A photosensitive recording element as claimed in claim 1, wherein from 10 to 60% of the carboxyl groups of the copolymer are esterified with glycidyl (meth)acrylate.

3. A photosensitive recording element as claimed in claim 1, wherein the copolymer has an acid number of from 20 to 100 mg of KOH/g.

4. A photosensitive recording element as claimed in any of claims 1 to 3, wherein the copolymer contains one or more N-vinyllactams as polymerized N-vinylamide comonomers.

5. A photosensitive recording element as claimed in claim 4, wherein the copolymer contains N-vinylpyrrolidone and/or N-vinylcaprolactam as polymerized N-vinyllactam.

6. A photosensitive recording element as claimed in any of claims 1 to 5, wherein the copolymer contains, as polymerized hydrophobic comonomers, styrene, styrenes which are substituted in the nucleus or in the side chain, vinyl acetate, alkyl acrylates and/or alkyl methacrylates.

**Claims for the contracting states : AT, ES**

1. A process for the production of a photosensitive recording element which is suitable for the production of printing plates or resist images and has a photopolymerizable recording layer which is applied to a dimensionally stable substrate, can be developed in an aqueous alkaline medium and contains a polymeric binder, one or more ethylenically unsaturated, photopolymerizable compounds and one or more photoinitiators, with or without further additives and/or assistants, said recording layer containing, as the polymeric binder, one or more film-forming copolymers of N-vinylamide, acrylic acid and/or methacrylic acid which are insoluble in water but soluble or dispersible in aqueous alkaline solutions and one or more hydrophobic comonomers which as such form homopolymers which are insoluble in water and aqueous alkaline solutions, wherein a copolymer of from 10 to 50% by weight of one or more N-vinylamides, from 8 to 30% by weight of acrylic acid and/or methacrylic acid and from 30 to 80% by weight of the hydrophobic comonomer is used, with the proviso that some of the carboxyl groups of the copolymer are esterified by reaction with glycidyl (meth)acrylate.

2. A process as claimed in claim 1, wherein from 10 to 60% of the carboxyl groups of the copolymer have been esterified with glycidyl (meth)acrylate.

3. A process as claimed in claim 1, wherein the copolymer used has an acid number of from 20 to 100 mg of KOH/g.

4. A process as claimed in any of claims 1 to 3, wherein one or more N-vinyllactams have been polymerized as N-vinylamide in the copolymer.

5. A process as claimed in claim 4, wherein N-vinylpyrrolidone and/or N-vinylcaprolactam have been polymerized as N-vinyllactam.

6. A process as claimed in any of claims 1 to 5, wherein styrene, styrenes which are substituted in the nucleus or in the side chain, vinyl acetate, alkyl acrylates and/or alkyl methacrylates have been polymerized as hydrophobic comonomers in the copolymer.

7. A process as claimed in any of claims 1 to 6, wherein a N-vinyllactam/(meth)acrylic acid/methyl methacrylate copolymer is used as the polymeric binder.

8. A process as claimed in any of claims 1 to 6, wherein an N-vinyllactam/(meth)acrylic acid/styrene copolymer is used as the polymeric binder.

9. A process as claimed in any of claims 1 to 8, wherein from 20 to 45% by weight of one or more N-vinylamides, from 10 to 40% by weight of acrylic acid and/or methacrylic acid and from 40 to 70% by weight of the hydrophobic comonomer have been polymerized for the preparation of the copolymer, the stated percentages each being based on the copolymer.

10. A process as claimed in any of claims 1 to 9, wherein monomers and/or oligomers having two or more acryloyl and/or methacryloyl groups are used as the ethylenically unsaturated, photopolymerizable compounds.

11. A process as claimed in any of claims 1 to 10, wherein the polymeric binders and the ethylenically unsaturated, photopolymerizable compounds are used in a weight ratio of from 1 : 99 to 90 : 10.

**Revendications**

**Revendications pour les Etats Contractants : BE, CH, DE, FR, GB, IT, LI, NL, SE**

1. Elément d'enregistrement sensible à la lumière, approprié à la fabrication de formes d'impression ou modèles de réserve ("resist"), ayant une couche d'enregistrement photopolymérisable, contenant un liant polymère, développable par voie aqueuse-alcaline, appliquée sur un support stable en dimension, qui contient, comme liant polymère, au moins un copolymérisat de N.-vinylamide, acide acrylique et/ou acide méthacrylique, filmogène, insoluble dans l'eau cependant soluble ou au moins dispersable dans des solutions aqueuses-alcalines, ainsi qu'au moins un comonomère hydrophobe qui forme des homopolymérisats insolubles, en tant que tels, dans l'eau et des solutions aqueuses-alcalines, caractérisé par le fait que le copolymérisat est constitué de 10 à 50% en poids d'au moins un N-vinylamide, 8 à 30% en poids d'acide acrylique et/ou acide méthacrylique ainsi que de 30 à 80% un poids du comonomère hydrophobe, sous réserve que les groupes carboxyle du copolymérisat sont partiellement estérifiés par réaction avec du (méth)acrylate de glycidyle.

2. Elément d'enregistrement sensible à la lumière, selon la revendication 1, caractérisé par le fait que 10 à 60% des groupes carboxyle de copolymérisat sont estérifiés par réaction avec du (méth)acrylate de glycidyle.

3. Elément d'enregistrement sensible à la lumière, selon la revendication 1, caractérisé par le fait que le copolymérisat présente un indice d'acide de 20 à 100 mg KOH/g.

4. Elément d'enregistrement sensible à la lumière, selon l'une des revendications 1 à 3, caractérisé par le fait que le copolymérisat contient en polymérisation, comme comonomère N-vinylamide, au moins un N-vinyllactame.

5. Elément d'enregistrement sensible à la lumière, selon la revendication 4, caractérisé par le fait que le copolymérisat contient, en polymérisation, comme N-vinyllactame, du N-vinylpyrrolidine et/ou N-vinylcaprolactame.

6. Elément d'enregistrement sensible à la lumière, selon l'une des revendications 1 à 5, caractérisé par le fait que le copolymérisat contient, en polymérisation, comme comonomère hydrophobe, du styrène, des styrènes substitués sur le noyau ou sur les chaînes latérales, de l'acétate de vinyle, de l'acrylate d'alkyle et/ou méthacrylate d'alkyle.

**Revendications pour les Etats Contractants : AT, ES**

1. Procédé de préparation d'un élément d'enregistrement sensible à la lumière, approprié à la fabrication de formes d'impression ou modèles de réserve ("resist"), ayant une couche d'enregistrement photopolymérisable, développable par voie aqueuse-alcaline, appliquée sur un support stable en dimension, contenant un liant polymère, au moins un composé photopolymérisable, insaturé éthyléniquement, au moins un photoinitiateur, ainsi qu'éventuellement d'autres additifs et/ou auxiliaires, couche qui contient, comme liant polymère, au moins un copolymérisat de N.-vinylamide/acide acrylique et/ou acide méthacrylique, filmogène, insoluble dans l'eau, cependant soluble ou au moins dispersable dans les solutions aqueuses-alcalines, ainsi qu'au moins un comonomère hydrophobe qui forme des homopolymérisats insolubles, en tant que tels, dans l'eau et des solutions aqueuses-alcalines, caractérisé par le fait qu'on fait réagir un copolymérisat constitué de 10 à 50% en poids d'au moins un N-vinylamide, 8 à 30 % en poids d'acide acrylique et/ou acide méthacrylique ainsi que de 30 à 80% un poids du comonomère hydrophobe, sous réserve que les groupes carboxyle du copolymérisat sont partiellement estérifiés par réaction avec du (méth)acrylate de glycidyle.

2. Procédé selon la revendication 1, caractérisé par le fait que 0 à 60% des groupes carboxyle de copolymérisat sont estérifiés par réaction avec du (méth)acrylate de glycidyle.

3. Procédé selon la revendication 1, caractérisé par le fait qu'on fait réagir un copolymérisat qui présente un indice d'acide de 20 à 100 mg KOH/g.

4. Procédé selon l'une des revendications 1 à 3, caractérisé par le fait que dans le copolymérisat a été mis en polymérisation, comme comonomère N-vinylamide, au moins un N-vinyllactame.

5. Procédé selon la revendication 4, caractérisé par le fait qu'ont été mis en polymérisation, comme N-vinyllactames, du N-vinylpyrrolidine et/ou N-vinylcaprolactame.

6. Procédé selon l'une des revendications 1 à 5, caractérisé par le fait que, dans le copolymérisat, ont été mis en polymérisation, comme comonomères hydrophobes, du styrène, des styrènes substitués sur le noyau ou sur les chaînes latérales, de l'acétate de vinyle, de l'acrylate d'alkyle et/ou méthacrylate d'alkyle.

7. Procédé selon l'une des revendications 1 à 6, caractérisé par le fait que, comme liant polymère, a été mis en réaction un copolymérisat N-vinyllactame/acide (méth)acrylate/méthacrylate de méthyle.

8. Procédé selon l'une des revendications 1 à 6, caractérisé par le fait que, comme liant polymère, a été mis en réaction un copolymérisat N-vinyllactame/acide (méth)acrylique/styrène.

9. Procédé selon l'une des revendications 1 à 8, caractérisé par le fait que, pour la préparation du copolymérisat, ont été mis en polymérisation 20 à 45% en poids d'au moins un N-vinylamide, 10 à 40% en poids d'acide acrylique et/ou acide méthacrylique, ainsi que 40 à 70% en poids du comonomère hydrophobe, les pourcentages indiqués se rapportant chacun au copolymérisat.

10. Procédé selon l'une des revendications 1 à 9, et comme composés photopolymérisables, insaturés, éthyléniquement, ont été mis à réagir des monomères et/ou oligomères à deux ou plus de deux groupes acryloyle et/ou méthacryloyle.

11. Procédé selon l'une des revendications 1 à 10, caractérisé par le fait que le liant polymère et les composés photopolymérisables, insaturés, éthyléniquement, ont été mis à réagir dans les rapports en poids de 1/99 à 90/10.